**Europäisches Patentamt**

**European Patent Office**

**Office européen des brevets**

(19)

(11) **EP 1 271 767 A1**

(12) # DEMANDE DE BREVET EUROPEEN

(43) Date de publication:
**02.01.2003 Bulletin 2003/01**

(51) Int Cl.⁷: **H03F 3/60**

(21) Numéro de dépôt: **02291506.0**

(22) Date de dépôt: **17.06.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **28.06.2001 FR 0108543**

(71) Demandeur: **ALCATEL**
**75008 Paris (FR)**

(72) Inventeurs:
- **Mouzannar, Wissam**
  **91120 Palaiseau (FR)**
- **Lefevre, René**
  **78160 Marly le Roy (FR)**

(74) Mandataire: **Fournier, Michel Robert Marie et al**
**COMPAGNIE FINANCIERE ALCATEL**
**Dépt. Propriété Industrielle,**
**30, avenue Kléber**
**75116 Paris (FR)**

(54) **Dispositif de polarisation à large bande de fréquences d'un circuit électronique et amplificateur l'incorporant**

(57) L'invention concerne un dispositif de polarisation à large bande de fréquences d'un circuit électronique, caractérisé en ce qu'il comprend une résistance (Rd) connectée en série avec une ligne de transmission prévue pour avoir une impédance caractéristique sensiblement égale à la valeur de ladite résistance (Rd), ladite ligne de transmission comprenant une ligne conductrice (TL) et une pluralité de sources de courant (T'1, T'2, T'3. . .) distribuées le long de ladite ligne conductrice (TL).

Le dispositif de polarisation selon l'invention peut être utilisé comme source de polarisation et/ou d'adaptation pour tout type d'application de puissance, à large bande et faible bruit, qui nécessite donc de forts courants de polarisation.

Fig. 4

**Description**

La présente invention concerne un dispositif de polarisation d'un circuit électronique et, plus particulièrement, l'invention se rapporte à une charge active distribuée à large bande utilisée comme source de polarisation de différents circuits électroniques pour des applications de puissance à large bande (et faible bruit) de type hyperfréquence, et notamment des circuits électroniques de type amplificateurs de puissance.

En effet, dans le contexte des systèmes de transmission à haut débit sur fibres optiques (c'est-à-dire supérieur à 40 Gbits/s), l'utilisation d'amplificateurs de puissance intégrés à large bande, fonctionnant du continu jusqu'à des fréquences élevées supérieures à 100 Giga Hertz (GHz), est très largement répandue.

Ils sont par exemple utilisés pour commander des modulateurs électro-optiques qui sont des dispositifs optiques dans lesquels la propagation de la lumière peut être modifiée par l'application d'un champ électrique particulier, typiquement 3 volts crête à crête pour un modulateur du type à électro-absorption et plus de 6 volts crête à crête pour un modulateur de type Lithium-Niobate.

Pour commander ce type de dispositifs optiques, il est nécessaire de mettre en oeuvre des circuits de commande à haute tension permettant une amplification de puissance à large bande.

De tels circuits de commande sont généralement basés sur des architectures de type amplificateur distribué.

En effet, par nature, le produit gain X largeur de bande d'un amplificateur de puissance distribué est élevé.

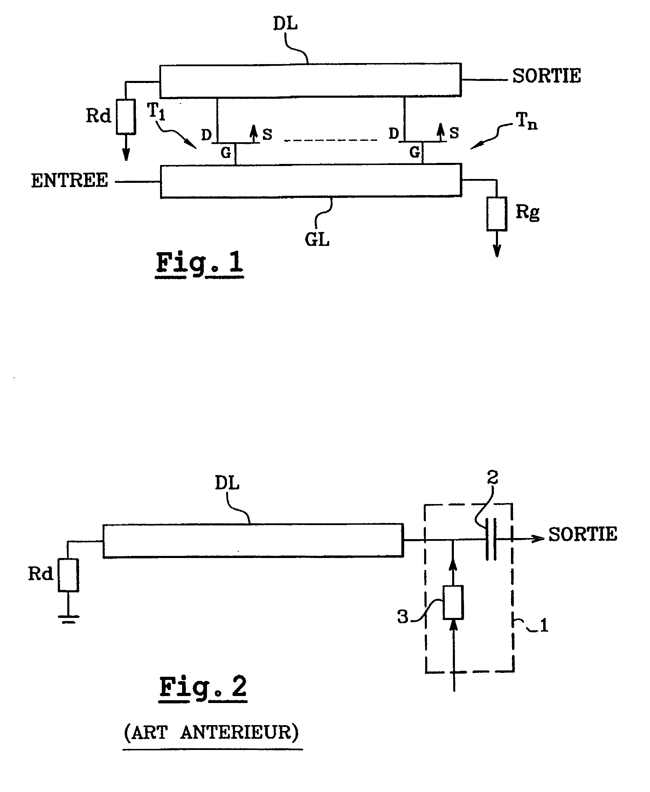

Le principe de fonctionnement d'un tel amplificateur est montré à la figure 1. Ainsi, plusieurs étages amplificateurs, respectivement T1 à Tn sont distribués régulièrement le long de deux lignes de transmission GL et DL, respectivement une ligne d'entrée et une ligne de sortie. Chaque ligne de transmission est en fait constituée de la ligne conductrice proprement dite, respectivement GL et DL, et des composants connectés le long de celle-ci.

Chaque étage amplificateur est constitué par un transistor de type transistor à effet de champ, par exemple un transistor MESFET, acronyme pour l'expression anglo-saxonne « Metal Semiconductor Field Effect Transistor ».

Ainsi, les deux lignes de transmission GL et DL sont respectivement nommées ligne de transmission de grille et ligne de transmission de drain.

Néanmoins, des transistors bipolaires peuvent être mis en oeuvre et se substituer aux transistors à effets de champ pour former chaque étage amplificateur T1 à Tn.

Dans ce cas, les deux lignes de transmission le long desquelles sont distribués les étages amplificateurs seront nommées ligne de transmission de base et ligne de transmission de collecteur.

L'amplificateur distribué fonctionne comme suit : le signal d'entrée qui va être amplifié se propage le long de la ligne de transmission de grille GL pour être absorbée par la charge Rg, de valeur sensiblement égale à la valeur de l'impédance caractéristique de la ligne de transmission. L'impédance caractéristique de la ligne de transmission inclut l'impédance de la ligne conductrice proprement dite ainsi que les impédances équivalentes des composants connectés dessus.

Ainsi, lorsque la charge de la ligne de transmission prend la valeur de l'impédance caractéristique de la ligne, la ligne a typiquement le comportement d'une ligne de longueur infinie.

En d'autres termes, aucune énergie ne peut être réfléchie vers l'entrée de la ligne de grille GL.

Sur chaque grille G de chaque transistor T1 à Tn, constituant les différents étages d'amplificateur, passe donc une onde de tension se propageant de la gauche vers la droite.

Un courant est alors généré par chaque transistor et alimente la ligne de drain DL. Ce courant se propage pour moitié vers la charge Rd, pour moitié vers la sortie. La moitié qui va vers la sortie se superposera avec la même phase, pourvu que le temps de propagation inter-cellule soit identique sur la ligne de drain DL et sur la ligne de grille GL. L'amplification sera alors la somme des amplifications réalisés par chaque transistor.

Le signal retropropagé vers la charge interne Rd de ligne de drain DL sera totalement absorbé à condition que la charge Rd soit accordée (égale) à l'impédance caractéristique de la ligne de transmission DL.

Ainsi, dans cette ligne de sortie de l'amplificateur de puissance distribué, la partie du courant injecté circulant à destination de la charge interne Rd sera dissipée et perdue et aucune énergie ne sera réfléchie à destination de la charge de sortie.

Cette condition est indispensable pour éviter d'éventuelles ondulations sur la réponse fréquentielle ou des échos sur la réponse impulsionnelle et pour préserver aussi les performances de l'amplificateur de puissance distribué, notamment en terme de linéarité. En effet, la non-linéarité d'un amplificateur est une cause importante de distorsion.

Les amplificateurs distribués tels que décrits précédemment nécessitent un fort courant de polarisation, supérieur à 100 milli-ampères (mA), pour délivrer la tension de sortie requise.

En effet, ces amplificateurs de puissance doivent fournir un courant élevé, de nombreux transistors sont donc nécessaires, ce qui fait que les courants de polarisation sont élevés.

Dans de nombreuses applications, le problème qui se pose alors est de polariser les transistors constituant les étages amplificateurs répartis le long des deux lignes de transmission sans dégrader les performances de l'amplificateur distribué.

Jusqu'à maintenant, deux types de solutions sont utilisées dans l'art antérieur pour polariser un amplificateur distribué. Ces solutions de l'art antérieur sont présentées dans l'ouvrage suivant : « Fundamentals of distributed amplification », par Thomas T.Y. Wong, paru en 1993 et disponible à la librairie Artech House Boston. London.

Cependant, dans le contexte de la présente invention se rapportant plus particulièrement aux applications de puissance à large bande, aucune de ces solutions de l'art antérieur présentée dans cet ouvrage n'est pleinement satisfaisante.

Tout d'abord, une première solution consiste à polariser le drain des transistors formant chaque étage amplificateur de l'amplificateur distribué par la sortie de la ligne de transmission de drain DL, voir à la figure 2.

Les différents étages amplificateurs ne sont pas représentés sur cette figure, ni la ligne de transmission de grille.

Ainsi, un circuit de polarisation classique en «T» 1 est placé à la sortie de l'amplificateur distribué par l'intermédiaire duquel une source de tension de polarisation est appliquée.

Ce circuit de polarisation comprend une capacité de découplage 2 et une bobine d'arrêt 3 dont la valeur d'inductance est élevée.

Le rôle de la capacité de découplage 2 est d'assurer une bonne isolation de la sortie de l'amplificateur distribué par rapport à la tension continue de polarisation.

En effet, derrière la sortie de l'amplificateur, se trouvent différents modules, tels que des modulateurs électro-optiques par exemple.

Quant à la bobine d'arrêt 3, son rôle est d'arrêter la composante à haute fréquence du courant tout en laissant passer la composante à basse fréquence, de façon à ne pas perturber le fonctionnement hyperfréquence de l'amplificateur de puissance à large bande.

Toutefois, bien que ce montage classique pour polariser un amplificateur distribué fournisse un courant de polarisation satisfaisant aux transistors formant les étages amplificateurs le long de la ligne de transmission, il présente un certain nombre d'inconvénients.

Tout d'abord, ce montage n'est pas intégré. Il se trouve donc en dehors de la puce sur laquelle est formé l'amplificateur distribué. En effet, de part la place nécessaire à la réalisation de ce montage, due essentiellement à la grande taille requise pour la bobine d'arrêt, il nécessite la mise en oeuvre d'un module à part.

De plus, dans le cas de certaines applications, par exemple les applications où l'amplificateur distribué commande en sortie un modulateur électro-optique, un deuxième circuit de polarisation en « T » sera nécessaire pour polariser le modulateur électro-optique.

Cette solution n'est donc pas du tout optimale en terme de capacité d'intégration.

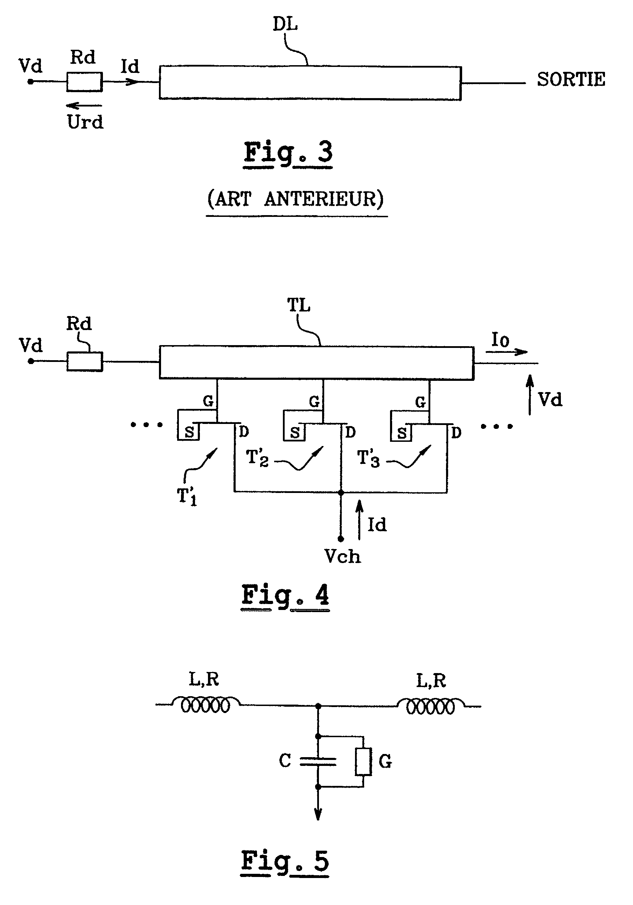

Une autre solution classique de l'art antérieur consiste alors à polariser les transistors directement à travers la résistance de drain Rd de la ligne de drain DL, voir à la figure 3.

De la même façon qu'à la figure 2, les différents étages amplificateurs de l'amplificateur distribué ne sont pas représentés, ni non plus la ligne de grille.

Cette solution est complètement intégrée et permet d'éviter d'utiliser un circuit de polarisation en «T» à la sortie de l'amplificateur distribué.

Cependant, comme déjà expliqué plus haut, de tels amplificateurs de puissance distribués nécessitent des courants de polarisation très élevés, d'intensité supérieure à 100 mA.

Ces valeurs très élevées du courant de polarisation entraînent inévitablement des contraintes en terme d'échauffement rendant nécessaire la mise en oeuvre d'une résistance de drain Rd de très grande taille, d'où une capacité parasite de la résistance Rd très élevée. Cette capacité parasite élevée pose problème, notamment en haute fréquence, où la résistance Rd ne se comporte plus comme une résistance pure et où l'effet de cette capacité parasite n'est plus négligeable.

Ainsi, avec le temps, à cause de l'échauffement de la résistance provoqué par les courants de polarisation élevés, la résistance ne fonctionne plus dans sa zone linéaire. Ce comportement se retrouve également en fonctionnement haute fréquence.

Les performances de la résistance Rd se dégradent alors et donc, le courant de polarisation des transistors répartis le long de la ligne de sortie DL de l'amplificateur distribué n'est plus stable et fluctue fortement.

De plus, les caractéristiques de la résistance se dégradant avec le temps du fait des forts courants de polarisation, sa valeur s'écarte de la valeur de l'impédance caractéristique de la ligne de sortie DL et par conséquent, l'adaptation d'impédance à la sortie de l'amplificateur de puissance n'est plus réalisée.

Les performances de l'amplificateur s'en trouvent donc fortement dégradées.

Prenons un exemple numérique pour illustrer le phénomène de dissipation de puissance dans la résistance Rd. Soient un courant de polarisation Id=200 mA et une résistance Rd = 50Ω.

La chute de tension Urd produite aux bornes de la résistance Rd est donc égale à 10 volts (V) et la puissance dissipée dans la résistance Rd est égale à $Pd=Rd.Id^2=2$ watts (W) .

Ainsi, bien que la puissance réellement nécessaire pour l'amplificateur est simplement de 1,4W pour une source de polarisation de 200mA sous 7V, la source de tension de polarisation devant être effectivement appliquée sera Vd=17V et la consommation de puissance totale sera de 3,4W, de façon à tenir compte de la chute de tension aux bornes de Rd et de la puissance dissipée dans Rd. On passe donc d'une tension d'alimentation de 7 V à 17 V et d'une puissance fournie de 1.4 W à 3.4 W.

La source de tension de polarisation et la puissance dissipée sont donc plus élevées que nécessaire.

Enfin, la puissance dissipée sur la puce de l'amplificateur de puissance peut poser des problèmes pour l'encapsulation des composants, à cause de l'élévation de température induite.

Aussi, un des buts que se propose d'atteindre la présente invention est de mettre en oeuvre un dispositif de polarisation adapté aux applications de puissance à large bande.

En particulier, l'invention a pour but de proposer un dispositif de polarisation capable de délivrer le courant nécessaire pour polariser tous les transistors d'un amplificateur distribué, tout en permettant une adaptation optimale de l'impédance à la sortie de l'amplificateur et ce, sans dégrader aucunement les caractéristiques et performances de l'amplificateur de puissance sur toute la plage de fréquence de travail.

A cet effet, pour résoudre les problèmes ci-dessus, l'invention prévoit d'utiliser une charge active distribuée à large bande de fréquences comme source de polarisation notamment pour les amplificateurs de puissance distribués, cette application n'étant nullement restrictive de la portée de l'invention.

En effet, plus généralement, le dispositif de polarisation selon l'invention peut être utilisé comme source de polarisation pour tout type d'application de puissance à large bande, qui nécessite donc de forts courants de polarisation.

L'invention concerne donc un dispositif de polarisation d'un circuit électronique, caractérisé en ce qu'il comprend une résistance connectée en série avec une ligne de transmission prévue pour avoir une impédance caractéristique sensiblement égale à la valeur de ladite résistance, ladite ligne de transmission comprenant une ligne conductrice et une pluralité de sources de courant distribuées le long de ladite ligne conductrice.

Selon un mode de réalisation conforme à l'invention, le dispositif de polarisation présente une caractéristique avantageuse en ce que chaque source de courant comprend un transistor à effet de champ dont l'électrode de grille et l'électrode de source sont reliées ensembles et connectées à la ligne conductrice afin de maintenir un courant constant de son drain vers sa source.

Le dimensionnement de la ligne de transmission est de façon avantageuse dimensionné pour respecter la condition suivante, de façon à rendre l'impédance caractéristique de ladite ligne indépendante de la fréquence :

$$\frac{L}{R} = \frac{C}{G}$$

avec :

L = valeur de l'inductance entre deux étages de la ligne de transmission;

R = pertes de l'inductance ou pertes de lignes entre deux étages de la ligne de transmission;

G = conductance drain-source de la source de courant;

C = capacité entre le drain et la source de la source de courant, qui tient compte de la capacité de la ligne de transmission sur laquelle la source de courant est montée.

L'invention concerne également un amplificateur de puissance caractérisé en ce qu'il est polarisé par le dispositif de polarisation tel qu'il vient d'être décrit.

D'autres caractéristiques et avantages de l'invention apparaîtront plus clairement à la lecture de la description suivante d'un exemple particulier de réalisation en référence aux figures annexées, données à titre d'exemple non limitatif, dans lesquelles :

- la figure 1 est un schéma illustrant le fonctionnement d'un amplificateur de puissance distribué et a déjà été décrite ;
- la figure 2 est un schéma illustrant une première méthode pour polariser un amplificateur distribué selon l'art antérieur et a déjà été décrite précédemment ;
- la figure 3 est un schéma illustrant une seconde méthode pour polariser un amplificateur distribué selon l'art antérieur et a déjà été décrite précédemment ;
- la figure 4 est un schéma illustrant la charge active distribuée utilisée comme source de polarisation selon la présente invention ;
- la figure 5 est un schéma illustrant le circuit électrique équivalent représentant un étage de la charge active distribuée selon la présente invention.

Ainsi, à la figure 4, la charge active distribuée selon l'invention comprend une résistance Rd connectée en série avec une ligne de transmission comprenant d'une part, la ligne conductrice proprement dite TL et, d'autre part, une pluralité de sources de courant distribuées le long de celle-ci. Les sources de courant sont représentées à titre d'exemple non limitatif au nombre de trois sur la figure 4, respectivement T'1, T'2, T'3.

Le dispositif selon l'invention peut être mis en oeuvre pour polariser un amplificateur de puissance distribué tel que celui représenté à la figure 1, et plus généralement pour polariser tout type d'amplificateur distribué, classique ou non.

Chaque source de courant peut être constituée avantageusement d'un transistor à effet de champ (selon un autre mode de réalisation, chaque source de courant peut être constituée d'un transistor de type bipolaire).

La ligne de transmission est prévue pour avoir une impédance caractéristique Zc de valeur sensiblement égale à la valeur de la résistance Rd. L'impédance caractéristique de la ligne de transmission inclut donc l'impédance de la ligne conductrice TL et les impédances équivalentes des transistors connectés dessus.

Les électrodes grille G et source S de chacun des transistors à effet de champ T'1, T'2, T'3 sont reliées ensemble de façon à maintenir un courant drain-source constant et sont connectées à la ligne de transmission TL.

Ainsi chaque transistor est utilisé en mode de saturation rendant le courant debité insensible aux tensions de polarisation.

L'électrode de drain D de chacun des transistors est quant à elle connectée à une source de tension Vch permettant de polariser les transistors de la charge active.

Quant à la tension d'alimentation des transistors de la partie amplificatrice, elle est fixée par la source de tension Vd.

Chaque transistor à effet de champ T'1, T'2, T'3, utilisé comme une charge active, est donc distribué le long de la ligne TL et le dispositif résultant formant une charge active distribuée est placé entre la résistance Rd et la ligne de drain DL d'un amplificateur de puissance distribué tel que représenté à la figure 1, dans le cas où le dispositif selon l'invention est utilisé comme source de courant d'un tel amplificateur.

La charge active distribuée selon l'invention regroupe en fait deux fonctions essentielles mises en oeuvre par le même dispositif.

Tout d'abord, le rôle de la charge active distribuée est de polariser les différents transistors de l'amplificateur de puissance distribué.

Le courant de polarisation Id des transistors de l'amplificateur est alors délivré par la charge active distribuée et ainsi, il ne passe quasiment plus de courant continu à travers la résistance Rd.

Le courant traversant Rd étant nul ou pratiquement nul, la résistance Rd ne s'échauffe plus et tous les problèmes de l'art antérieur induits par cet échauffement (déjà mentionnés plus haut dans la description) sont évités et la stabilité thermique de l'amplificateur s'en trouve par conséquent fortement améliorée.

L'avantage aussi est que quelque soit le courant débité par la charge active pour polariser l'amplificateur, la tension sur les transistors des différents étages distribués n'est pas modifiée; cela permet d'améliorer la linéarité des amplificateurs.

De plus, le courant de polarisation Id délivré par le dispositif de polarisation selon l'invention est réglable.

Ainsi, en retirant ou en rajoutant des étages à la charge active distribuée, le courant de polarisation peut être adapté.

Par exemple, si dans une application quelconque, un courant de polarisation de 200 mA est nécessaire et que chaque transistor faisant office de charge active, réparti le long de la ligne de transmission TL est prévu pour délivrer 10 mA, alors 20 transistors devront être distribués pour réaliser la charge active distribuée voulue.

Enfin, le courant de polarisation fourni par la charge active distribuée selon l'invention est beaucoup plus stable, notamment par rapport à la solution de l'art antérieur la plus courante où la polarisation des transistors de l'amplificateur de puissance est effectuée directement à travers la résistance Rd. De cette façon, la linéarité de l'amplificateur est nettement améliorée. Ses performances s'en trouvent donc également améliorées.

Une seconde fonction avantageuse de la charge active distribuée selon l'invention utilisée comme source de courant d'un amplificateur de puissance distribué, est de respecter l'impédance caractéristique de la ligne de drain de l'amplificateur de façon à avoir une même valeur de la résistance Rd qui charge la ligne de drain de l'amplificateur distribué, et ce sur toute la plage de fréquence de travail de l'amplificateur allant du continu jusqu'à des fréquences supérieures à 60 GHz.

En fait, pour ce qui est du fonctionnement de charge d'adaptation, la charge active distribuée peut être assimilée à une ligne de transmission simple.

En effet, l'impédance caractéristique de la ligne de transmission, incluant l'impédance de la ligne conductrice TL et les impédances équivalentes des sources de courant T'1, T'2, T'3, est prévue pour être sensiblement égale à la valeur de la résistance Rd, soit 50 Ω dans notre exemple. La charge active distribuée étant chargée en entrée par la résistance Rd, on trouve alors également la même valeur de résistance en sortie de la charge active distribuée, soit en entrée de l'amplificateur distribué.

Ainsi, la ligne de drain de l'amplificateur de puissance distribué, dont l'impédance caractéristique équivaut à la valeur de la résistance Rd, est toujours adaptée.

Dans le cas contraire où l'adaptation d'impédance ne serait pas réalisée et où la ligne de drain de l'amplificateur distribué ne serait donc pas chargée par une charge égale à la valeur de la résistance Rd, de nombreux phénomènes de réflexion et d'ondulation se produiraient au sein de celle-ci et beaucoup d'énergie serait perdu.

La longueur totale de la ligne de transmission de la charge active distribuée selon l'invention est donc calculée de façon à ce que l'impédance caractéristique de la charge active distribuée soit égale à la valeur de la résistance Rd afin d'adapter l'impédance à la sortie de l'amplificateur distribué.

La figure 5 illustre le circuit électrique équivalent représentant un étage de la charge active distribuée.

La ligne de transmission entre deux étages consécutifs de la charge active distribuée peut être modélisée par une bobine d'inductance et chaque charge active est modélisée par sa capacité drain-source et sa conductance drain-source.

L'impédance caractéristique de la charge active distribuée selon l'invention peut alors être calculée selon la formule suivante :

$$Zc= \sqrt{\frac{R+jLw}{G+jCw}}$$

Avec :

L = valeur de l'inductance entre deux étages de la ligne de transmission;
R = pertes de l'inductance ou pertes de lignes entre deux étages;
G = conductance drain-source de la charge active;
C = capacité drain-source de la charge active, qui tient compte de la capacité de la ligne de transmission sur laquelle la charge active est montée.

Les conditions de dimensionnement de la ligne de transmission à satisfaire pour rendre l'impédance caractéristique Zc indépendante de la fréquence, et donc pour permettre l'adaptation d'impédance de l'amplificateur de puissance distribué sur une bande de fréquence la plus large possible, sont fixées par la relation suivante entre les différentes variables définies plus haut :

$$\frac{L}{R}= \frac{C}{G}$$

Ainsi, en choisissant des valeurs adéquates pour R, L, G et C, une ligne de transmission artificielle est réalisée avec l'impédance caractéristique constante recherchée égale à 50 Ω dans notre exemple, sur une large plage de fréquence, de façon à assurer une adaptation d'impédance très large bande de l'amplificateur. La charge vue à l'entrée de l'amplificateur est donc pratiquement identique sur une très large bande fréquence.
Pratiquement, des logiciels de conception assistée sont mis en oeuvre pour ajuster les dimensionnements physiques de la ligne de transmission permettant d'obtenir le résultat souhaité.
Quant au nombre d'étages distribués le long de la ligne de transmission, il dépend du courant continu que la charge active distribuée doit délivrer.
Le dispositif selon l'invention permet donc de résoudre les principaux problèmes rencontrés avec les amplificateurs de puissance distribués, notamment la mise en oeuvre d'un courant de polarisation élevé et une adaptation d'impédance à large bande sans dégrader les performances de l'amplificateur, grâce à la caractéristique distribuée de la charge active utilisée comme source de polarisation.
De plus, l'invention permet l'utilisation de sources de tension de polarisation réduites pour les amplificateurs de puissance distribués par rapport à celles mises en oeuvre dans l'art antérieur, notamment dans le cas où la polarisation est effectuée directement à travers la résistance Rd.
Ainsi, cette caractéristique permet non seulement de minimiser la consommation et la dissipation thermique, mais aussi de s'adapter à des tensions d'alimentation standarisées 5 V ou 12 V.
Enfin, le dispositif de polarisation selon l'invention est complétement intégré et ne nécessite la mise en oeuvre d'aucun module externe à la puce sur laquelle est formé l'amplificateur de puissance distribué.
Toute la description précédente à été faite en se rapportant à la polarisation d'un amplificateur de puissance distribué, il est cependant clair que le dispositif décrit peut servir à polariser d'autres circuits électroniques présentant une structure distribuée dans des applications de puissance à large bande et même à faible bruit sans sortir aucunement du cadre de la présente invention.

**Revendications**

1. Dispositif de polarisation d'un circuit électronique, **caractérisé en ce qu'**il comprend une résistance (Rd) connectée en série avec une ligne de transmission prévue pour avoir une impédance caractéristique sensiblement égale à la valeur de ladite résistance (Rd), ladite ligne de transmission comprenant une ligne conductrice (TL) et une pluralité de sources de courant (T'1, T'2, T'3...) distribuées le long de ladite ligne conductrice (TL).

2. Dispositif selon la revendication 1, **caractérisé en ce que** chaque source de courant (T'1, T'2, T'3...) comprend un transistor à effet de champ dont l'électrode de grille (G) et l'électrode de source (S) sont reliées ensemble et connectées à la ligne conductrice (TL) afin de maintenir un courant constant de son drain (D) vers sa source (S).

3. Dispositif selon la revendication 2, **caractérisé en ce que** le dimensionnement de la ligne de transmission est dimensionné pour respecter la condition suivante, de façon à rendre l'impédance caractéristique de ladite ligne indépendante de la fréquence :

$$\frac{L}{R} = \frac{C}{G}$$

avec :

L = valeur de l'inductance entre deux étages de la ligne de transmission;
R = pertes de l'inductance ou pertes de lignes entre deux étages de la ligne de transmission;
G = conductance drain-source de la source de courant;
C = capacité entre le drain et la source de la source de courant.

4. Dispositif selon l'une des revendications précédentes, **caractérisé en ce que** le courant de polarisation (Id) délivré par ledit dispositif est réglable.

5. Amplificateur de puissance **caractérisé en ce qu'**il est polarisé par le dispositif selon l'une des revendications précédentes.

6. Amplificateur de puissance selon la revendication 6, **caractérisé en ce qu'**il est lui-même distribué.

**Fig. 1**

**Fig. 2**

(ART ANTERIEUR)

DL

Vd • — Rd — Id → [                    ] — SORTIE

← Urd

## Fig. 3

(ART ANTERIEUR)

TL

Vd • — Rd — [                    ] Io →

G        G        G        Vd ↑

... S | D   S | D   S | D ...

T'₁      T'₂      T'₃

Id ↑

Vch

## Fig. 4

L,R          L,R
⟿⟿⟿          ⟿⟿⟿

C ⊥⊥    ▯ G

↓

## Fig. 5

Office européen
des brevets

**RAPPORT DE RECHERCHE EUROPEENNE**

Numéro de la demande

EP 02 29 1506

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | CAPPELLO A ET AL: "A HIGH PERFORMANCE, QUASI-MONOLITHIC 2 TO 18 GHZ DISTRIBUTED GAAS FET AMPLIFIER" IEEE MTT-S INTERNATIONAL MICROWAVE SYMPOSIUM DIGEST. LAS VEGAS, JUNE 9 - 11, 1987, INTERNATIONAL MICROWAVE SYMPOSIUM, NEW YORK, IEEE, US, vol. 2, 9 juin 1987 (1987-06-09), pages 833-836, XP000094051 * page 833, colonne de droite - page 834, colonne de gauche; figure 4 * --- | 1 | H03F3/60 |
| A | WO 99 10987 A (KANGASLAHTI PEKKA ;KALAJO SAMI (FI); INSINOEOERITOIMISTO JUHANA YL) 4 mars 1999 (1999-03-04) * page 4, ligne 8 - ligne 19; figure 3 * * page 5, ligne 8 - page 6, ligne 14; figure 5 * --- | 1-3 | |
| A | EP 0 237 099 A (ELECTRONIQUE & PHYSIQUE ;PHILIPS NV (NL)) 16 septembre 1987 (1987-09-16) * page 3, ligne 45 - page 4, ligne 10; figure 1 * ----- | 1 | **DOMAINES TECHNIQUES RECHERCHES (Int.Cl.7)** H03F |

Le présent rapport a été établi pour toutes les revendications

| Lieu de la recherche | Date d'achèvement de la recherche | Examinateur |
|---|---|---|
| LA HAYE | 18 octobre 2002 | Tyberghien, G |

EPO FORM 1503 03.82 (P04C02)

**ANNEXE AU RAPPORT DE RECHERCHE EUROPEENNE
RELATIF A LA DEMANDE DE BREVET EUROPEEN NO.**  EP 02 29 1506

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-10-2002

| Document brevet cité au rapport de recherche | | Date de publication | Membre(s) de la famille de brevet(s) | | Date de publication |
|---|---|---|---|---|---|
| WO 9910987 | A | 04-03-1999 | FI | 973525 A | 28-02-1999 |
| | | | AU | 8865398 A | 16-03-1999 |
| | | | CA | 2302256 A1 | 04-03-1999 |
| | | | EP | 1016224 A2 | 05-07-2000 |
| | | | WO | 9910987 A2 | 04-03-1999 |
| | | | JP | 2002519907 T | 02-07-2002 |
| | | | US | 6346853 B1 | 12-02-2002 |
| EP 0237099 | A | 16-09-1987 | FR | 2595173 A1 | 04-09-1987 |
| | | | EP | 0237099 A1 | 16-09-1987 |
| | | | JP | 62206912 A | 11-09-1987 |
| | | | US | 4754234 A | 28-06-1988 |

EPO FORM P0460

Pour tout renseignement concernant cette annexe : voir Journal Officiel de l'Office européen des brevets, No.12/82